Europäisches Patentamt

European Patent Office

Office européen des brevets

(19)

(11) Veröffentlichungsnummer: **0 037 881**
**B1**

(12) # EUROPÄISCHE PATENTSCHRIFT

(45) Veröffentlichungstag der Patentschrift:
14.10.87

(51) Int. Cl.⁴: **H 05 K 7/14**

(21) Anmeldenummer: **81100977.8**

(22) Anmeldetag: **12.02.81**

(54) Einschubrahmen für Schaltungsplatten.

(30) Priorität: **14.04.80 DE 8010147 U**

(43) Veröffentlichungstag der Anmeldung:
**21.10.81 Patentblatt 81/42**

(45) Bekanntmachung des Hinweises auf die Patenterteilung:
**14.10.87 Patentblatt 87/42**

(84) Benannte Vertragsstaaten:
**DE FR GB IT NL**

(56) Entgegenhaltungen:
**DE-A-1 690 019**
**DE-B-1 275 172**
**FR-A-2 005 077**
**US-A-3 382 476**
**US-A-3 465 891**

(73) Patentinhaber: **Messerschmitt- Bölkow- Blohm Gesellschaft mit beschränkter Haftung, Robert- Koch- Strasse, D-8012 Ottobrunn (DE)**

(72) Erfinder: **Hübner, Rudolf, Kurfürstenallee 33a, D-2800 Bremen (DE)**
Erfinder: **Grabenhorst, Rolf, Habenh.- Landstrasse 255, D-2800 Bremen 61 (DE)**

(74) Vertreter: **Schramm, Ewald Werner Josef, Messerschmitt- Bölkow- Blohm GmbH Patentabteilung TW63 (TWB32) Postfach 10 78 45, D-2800 Bremen 1 (DE)**

**Beschreibung**

Die Erfindung bezieht sich auf einen Einschubrahmen für Schaltungsplatten mit paarweise einander zugekehrten, an den Seitenwänden und/oder Zwischenwänden angeordneten Führungsschienen sowie am Boden des Rahmens angebrachten Steckbuchsen zum Anschluß der Schaltungsplatten.

Bei elektronischen Steuerungen oder in der Nachrichtentechnik werden häufig Baueinheiten benutzt, die als in Gestelle oder Schranke einschiebbare Einschubrahmen ausgebildet sind. Diese Einschubrahmen sind zumeist so aufgebaut, daß an Seiten- und/oder Zwischenwänden paarweise einander zugekehrte Führungsschienen vorgesehen sind zum Halten der einzusteckenden Schaltungsplatten. Außerdem sind bei solchen Einschubrahmen am Boden Steckbuchsen vorgesehen zum elektrischen Anschluß der eingesteckten Schaltungsplatten.

Die bisher bekannt gewordenen Einschubrahmen sind zur Aufnahme der Steckbuchsen entsprechend ausgebildet, d.h., wenn aus bestimmten Gründen Steckbuchsen anderer Abmessungen einzusetzen sind, können diese in der Regel nicht eingebaut werden. Da es sich aber in der Praxis als notwendig erwiesen hat, Steckbuchsen verschiedener Art und verschiedener Abmessungen zu benutzen, war es bisher erforderlich, Sondermaßnahmen für die Aufnahme verschiedener Steckbuchsen bei den Einschubrahmen vorzusehen. Dies ist aber wegen der großen Vielfalt der Steckbuchsen einerseits und dem davon abhängigen Aufbau der Einschubrahmen andererseits unbefriedigend.

Aus den Dokumenten US-A-34 65 891 und DE-A-16 90 019 sind Maßnahmen bekannt, welche die Verwendung von Steckbuchsen mit unterschiedlichen Längen ermöglichen.

Der Erfindung liegt daher die Aufgabe zugrunde, einen Einschubrahmen der eingangs genannten Art zur universellen Aufnahme unterschiedlicher Steckbuchsen auszubilden. Gemäß der Erfindung wird diese Aufgabe dadurch gelöst, daß die Seiten- und/oder Zwischenwände am Boden des Rahmens Längsleisten aufweisen und durch Querstreben miteinander verbunden sind und daß die Querstreben vorbestimmte Gewindebohrungen besitzen zum wahlweisen Befestigen einer Zwischenleiste in Abhängigkeit der Maße der jeweils an der Zwischenleiste einerseits und den beiden Längsleisten andererseits anzubringenden Steckbuchsen.

Bei einer vorteilhaften Ausgestaltung der Erfindung ist die an den Querstreben befestigte Zwischenleiste in mehrere an verschiedenen Positionen der Querstreben befestigten Abschnitte aufgeteilt. Diese Maßnahme bietet die Möglichkeit, innerhalb eines Rahmenabschnittes Steckbuchsen verschiedenster Abmessungen zu benutzen. In diesem Zusammenhang ist es zweckmäßig, die an den Seitenwänden und/oder Zwischenwänden mittels Schrauben befestigten Längsleisten sowie die ebenfalls mittels Schrauben befestigten Zwischenleisten mit Gewindebohrungen zum Befestigen der Steckbuchsen zu versehen. Vorteilhaft ist es dabei auch, die an den Seiten- und/oder Zwischenwänden vorgesehenen Führungsschienen für die Schaltungsplatten durch Kanten von Führungsnuten zu bilden, die in an den Wänden angebrachten Kunststoffstreifen vorgesehen sind.

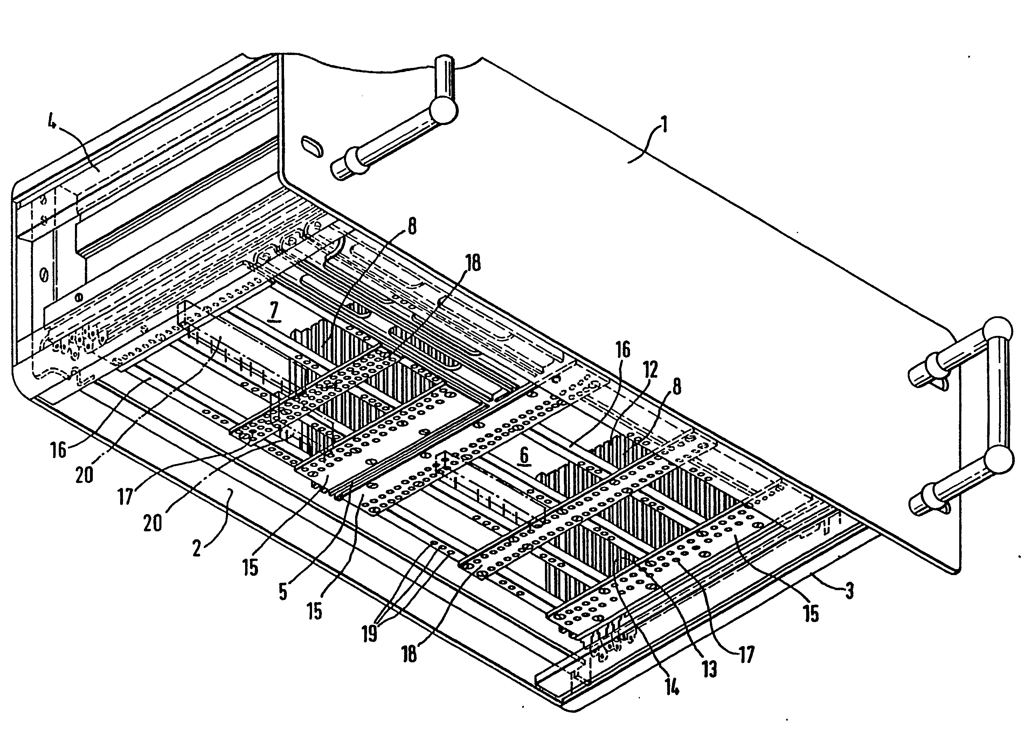

Die Erfindung wird anhand der beiliegenden Zeichnung näher erläutert. In der beiliegenden Zeichnung ist ein Einschubrahmen in Schrägdarstellung mit Blick von unten dargestellt, der aus der Stirnwand 1, der Rückwand 2, zwei Seitenwänden 3, 4 und einer Zwischenwand 5 besteht. Die Zwischenwand teilt daher den Einschubrahmen in zwei Raumabschnitte 6, 7 auf. Zu beiden Seiten der Zwischenwand 5 und auf den Innenseiten der Seitenwände 3, 4 ist jeweils ein breiter Kunststoffstreifen 8 annebracht, in denen über die Gesamtlänge von oben nach unten gerichtete und einander zugekehrte Führungsnuten 11 vorgesehen sind. Die Kanten 13, 14 dieser Führungsnuten 12 dienen als Führungsschienen für einzusteckende, nicht näher dargestellte Schaltungsplatten. Am Boden des Einschubrahmens sind an beiden Seitenwänden 3, 4 je eine Längsleiste 15 und an der Zwischenwand 5 zwei Längsleisten angeschraubt. Diese Längsleisten 15 enthalten Gewindebohrungen 17 zur Befestigung von Querstreben 16. Hierüber sind in gleichmäßigen Abständen, wie dargestellt, die Längsleisten 15 in den Raumabschnitten 6 bzw. 7 miteinander verbunden. Es ist aber auch möglich, die Querstreben 16 mit unterschiedlichen Abständen zueinander an den Längsleisten 15 zu befestigen. Die Querstreben 16 besitzen im Mittelbereich mehrere Gewindebohrungen 19, an denen in den Raumabschnitten 6 bzw. 7 jeweils eine Zwischenleiste 18 angeschraubt ist. Durch die Gewindebohrungen 19, die in den Querstreben 16 an vorbestimmten Positionen vorgesehen sind, besteht die Möglichkeit, die jeweilige Zwischenleiste 18 mit gleichen oder ungleichen Abständen zu den Längsleisten 15 zu befestigen. Wie aus der Darstellung hervorgeht, ist die Zwischenleiste 18 im rechten Raumabschnitt 6 mit gleichen Abständen zu den Längsleisten 15 angeschraubt, während im linken Raumabschnitt 7 die Zwischenleiste 18 mit unterschiedlichen Abständen befestigt ist. Auf diese Weise können somit zur Aufnahme von Steckbuchsen 20 unterschiedlicher Abmessungen, insbesondere unterschiedlicher Längen die erforderlichen baulichen Voraussetzungen durch einfaches Umsetzen einer Zwischenleiste 18 leicht geschaffen werden. Ein besonderer Vorteil ergibt sich noch dann, wenn eine Zwischenleiste 18 in mehrere Abschnitte unterteilt wird. Mit einer solchen Maßnahme ist es möglich, innerhalb eines Raumabschnitts die einzelnen Abschnitte einer Zwischenleiste 18 unterschiedlich an den entsprechenden Querstreben zu befestigen und so innerhalb eines Raumabschnitts Befestigungsmöglichkeiten für unterschiedliche Steckbuchsen 20 zu schaffen. Zur Befestigung der Steckbuchsen 20 dienen dabei die in den Längsleisten 15 und den Zwischenleisten 18 vorgesehenen Gewindebohrungen 17. Der erfindungsgemäße Aufbau eines Einschubrahmens bietet eine große Zahl von Variationsmöglichkeiten zur Aufnahme von Steckbuchsen 10 und kann somit ohne Zusatzaufwand leicht an die besonderen Bedürfnisse der Praxis angepaßt werden.

**Patentansprüche**

1. Einschubrahmen für Schaltungsplatten mit paarweise einander zugekehrten, an den Seitenwänden und/oder Zwischenwänden angeordneten Führungsschienen sowie am Boden des Rahmens angebrachten Steckbuchsen zum Anschluß der Schaltungsplatten, dadurch gekennzeichnet, daß die Seiten- und/oder Zwischenwände (3, 4, 5) am Boden des Rahmens Längsleisten (15) aufweisen und durch Querstreben (16) miteinander verbunden sind und daß die Querstreben (16) vorbestimmte Gewindebohrungen (19) besitzen zum wahlweisen Befestigen einer Zwischenleiste (18) in Abhängigkeit der Maße der jeweils an der Zwischenleiste (18) einerseits und einer der beiden Längsleisten (15) andererseits angebrachten Steckbuchsen (20).

2. Einschubrahmen nach Anspruch 1, dadurch gekennzeichnet, daß die an den Querstreben (16) befestigte Zwischenleiste (18) in mehrere an verschiedenen Positionen der Querstreben (16) befestigbare Abschnitte aufgeteilt ist.

3. Einschubrahmen nach Anspruch 1 oder 2, dadurch gekennzeichnet, daß die an den Seitenwänden (3, 4) und/oder Zwischenwänden (5) mittels Schrauben befestigten Längsleisten (15) sowie die ebenfalls mittels Schrauben an den Querstreben (16) befestigten Zwischenleisten (18) Gewindebohrungen (17) zum Befestigen der Steckbuchse (20) aufweisen.

4. Einschubrahmen nach einem der Ansprüche 1 bis 3, dadurch gekennzeichnet, daß die an den Seiten und/oder Zwischenwänden (3, 4, 5) vorgesehenen Führungsschienen für die Schaltungsplatten durch Kanten (13, 14) von Führungsnuten (12) gebildet sind, die in an den Wänden angebrachten Kunststoffstreifen (8) vorgesehen sind.

**Claims**

1. A slide-in frame for circuit boards having guide rails in pairs facing one another on the side and/or intermediate walls, and plug connectors for connecting with the boards at the bottom of the frame, charecterised in that the side and/or intermediate walls (3, 4, 5) have elongate supports (15) at the base of the frame and are connected together by crossbars (16), these having predetermined tapped holes (19) for fixing as decided of an intermediate support (18) depending on the size of the plug connectors (20) fitted at one side of the intermediate support (18) and at the other side on one of the two elongate supports (15).

2. A slide-in frame according to claim 1, wherein the intermediate support (18) fixed to the crossbars (16) is divided into several sections fixable at different positions of the crossbars (16).

3. A slide-in frame according to claim 1 or 2, wherein the elongate supports (15) fitted by screws to the side walls (3, 4) and/or the intermediate walls (5), and the intermediate supports (18) also fitted by screws to the cross bars (16), have tapped holes (17) for fixing the plug connector.

4. A slide-in frame according to one of claims 1 to 3, wherein the guide rails for the circuit board · provided on the side and/or intermediate walls are formed by edges (13, 14) of guide grooves (12) provided in plastics strips (8) attached to the walls.

**Revendications**

1. Glissières pour cartes à circuits imprimés avec des glissières de guidage arrangées par paires, tournées l'une vers l'autre, sur les parois latérales et/ou les parois intermédiaires, ainsi que connecteurs enfichables disposes sur le fond de la glissière pour le raccordement des cartes à circuit imprimé, caractérisées en ce que les parois latérales et/ou intermédiaires (3, 4, 5) présentent des bandes longitudinales (15) sur le fond de la glissière et sont reliées entre elles par des entretoises (16) et que les entretoises (16) présentent des alésages filetés (19) prédéterminés pour fixer au choix une bande intermédiaire (18) en fonction des dimensions des connecteurs enfichables (20) adjoints à la bande intermédiaire (18) d'un côté et à l'une des deux bandes longitudinales (15) de l'autre côté.

2. Glissières selon la revendication 1, caractérisées en ce que les bandes intermédiaires (18) fixées aux entretoises (16) sont subdivisées en plusieurs sections fixables en différentes positions des entretoises (16).

3. Glissières selon la revendication 1 ou 2, caractérisée en ce que les bandes longitudinales (15) fixées au moyen de vis aux parois latérales (3, 4) et/ou intermédiaires (5), ainsi que les bandes intermédiaires (18) fixées également par vis aux entretoises (16) présentent des alésages filetés (17) pour la fixation des connecteurs enfichables (20).

4. Glissières selon l'une des revendications 1 à 3, caractérisées en ce que les glissières de guidage, prévues sur les parois latérales et/ou les parois intermédiaires (3, 4, 5) pour les cartes à circuits imprimés, sont formées par des arêtes (13, 14) de rainures de guidage (12), qui sont prévues dans les bandes en matière plastique (8) adjointes aux parois.